# EUROPEAN PATENT APPLICATION

(11) **EP 2 597 712 A1**
(43) Date of publication of application: **29.05.2013**
(21) Application number: 10810814.3
(22) Date of filing: 25.06.2010
(51) Int. Cl.: H01M 8/04, H01M 8/10

(54) **FUEL CELL SYSTEM**

(71) Applicant: TOYOTA JIDOSHA KABUSHIKI KAISHA, Toyota-shi, Aichi-ken, 471-8571 (JP)
(72) Inventor: KUMEI, Hideyuki, Toyota-shi, Aichi 471-8571 (JP); KAWAHARA, Shuya, Toyota-shi, Aichi 471-8571 (JP)
(74) Representative: Albutt, Anthony John
(86) International application number: PCT/JP2010/004238
(87) International publication number: WO 2011/161731

(57) **Abstract**

A fuel cell system includes a first power generation module configured to have a power generation assembly including a catalyst, an anode-side non-power generation structure placed in contact with the power generation assembly, and a cathode-side non-power generation structure placed on opposite to the power generation assembly across the power generation assembly, at least one second power generation module placed adjacent to the first power generation module, and a current regulation circuit connected in parallel to each of the power generation modules. The fuel cell system has a current controller configured to, when a cell voltage representing a voltage between the anode-side non-power generation structure and the cathode-side non-power generation structure is not higher than a preset first voltage that is a negative voltage, control the current regulator connected in parallel to the first power generation module to increase an amount of electric current flowing in a first direction from the anode-side non-power generation structure to the cathode-side non-power generation structure.

## Description

### BACKGROUND OF THE INVENTION

### 1. Field of the invention

The present invention relates to a fuel cell structured to generate electric power through chemical reactions of a fuel gas and an oxidizing gas.

### 2. Description of the Related Art

In the fuel cell structured to generate electric power through the chemical reactions of the fuel gas and the oxidizing gas, even after an operation stop, the power generation continues with the remaining fuel gas and the remaining oxidizing gas to generate an open circuit voltage. The open circuit voltage causes catalyst deterioration, such as corrosion of carbon included in a catalyst layer of the fuel cell or elution of a catalyst metal. Diverse techniques have been proposed to lower the open circuit voltage. The catalyst deterioration also occurs when the fuel cell has a negative voltage. In a fuel gas deficient condition of some fuel cell included in a fuel cell stack, an increase in anode potential in the fuel cell causes a negative voltage. In this state, even the fuel cell having deficiency of the fuel gas tries to make a flow of electric current at the same level as that in the other fuel cells. This may lead to oxidation of carbon included in the catalyst.

On the occurrence of oxidation of carbon by the negative voltage of the fuel cell, an effective catalyst area is narrowed to lower the power generation efficiency. None of the proposed techniques has sufficiently prevented such catalyst deterioration in the condition of the fuel cell having a negative voltage.

### SUMMARY

By taking into account at least part of the issue discussed above, there is a requirement for preventing or at least restricting catalyst deterioration in a condition of a fuel cell having a negative voltage.

In order to address at least part of the requirement described above, the present invention provides various aspects and applications described below.

[Aspect 1] According to an aspect of the present invention, a fuel cell system is provided. The fuel cell system comprises: a first power generation module includes a power generation assembly including a catalyst, an anode-side non-power generation structure placed in contact with the power generation assembly, and a cathode-side non-power generation structure placed opposite to the power generation assembly across the power generation assembly; a second power generation module placed adjacent to the first power generation module; a current regulation circuit connected in parallel to each of the power generation modules; and a current controller configured to, when a cell voltage representing a voltage between the anode-side non-power generation structure and the cathode-side non-power generation structure is not higher than a preset first voltage that is a negative voltage, control the current regulator connected in parallel to the first power generation module to increase an amount of electric current flowing in a first direction from the anode-side non-power generation structure to the cathode-side non-power generation structure.

In the fuel cell system according to the aspect 1 of the invention, when the cell voltage of the first power generation module is not higher than the preset first voltage, the current regulation circuit is controlled to increase the amount of electric current flowing in the first direction. Electrons can thus be supplied to the adjacent second power generation module via the current regulation circuit. In a hydrogen deficient condition of the first power generation module, such supply of electrons to the second power generation module inhibits chemical reactions accompanied with generation of electrons at an anode of the first power generation module. This arrangement effectively prevents or at least restricts oxidation of carbon at the anode, thus preventing or at least restricting reduction of the power generation efficiency.

[Aspect 2] In the fuel cell system described in the aspect 1, the current controller includes an electric current direction detector configured to detect a direction of electric current flowing in the current regulation circuit connected in parallel to the first power generation module, and the current controller determines whether the cell voltage is not higher than the preset first voltage, based on the direction of electric current detected by the electric current direction detector.

The fuel cell system of the aspect 2 assures accurate detection of a state in which chemical reactions in a normal power generation condition are inhibited by, for example, deficiency of the fuel gas, in the power generation module but the chemical reactions accompanied with generation of electrons tend to proceed at the anode.

[Aspect 3] In the fuel cell system described in either one of aspect 1 and 2, when the cell voltage is higher than the preset first voltage and is higher than a preset second voltage that causes elution of the catalyst, the current controller controls the current regulation circuit connected in parallel to the first power generation module to increase an amount of electric current flowing in a second direction opposite to the first direction.

In the fuel cell system of the aspect 3, when the cell voltage of the first power generation module is higher than the preset second voltage, electrons generated through the chemical reactions in the normal power generation condition can be supplied from the cathode to the anode of the first power generation module via the current regulation circuit. An electromotive force induced in the first power generation module is accordingly consumed as heat in the current regulation circuit. In an OC (Open Circuit) state of a fuel cell stack, such heat consumption lowers the cell voltage of the first power generation module and thereby prevents or at least restricts elution of the catalyst caused by a high voltage.

[Aspect 4] In the fuel cell system described in any one of aspects 1 through 3, the current regulation circuit and the current controller include a diode.

In the fuel cell system of the aspect 4, on a condition that (an absolute value of) the preset first voltage is greater than (an absolute value of) a forward voltage drop of the diode, the current regulation circuit is controlled to increase the amount of electric current flowing in the first direction in the current regulation circuit when the cell voltage of the first power generation module is not higher than the preset first voltage, while being controlled to decrease the amount of electric current flowing in the first direction in the current regulation circuit when the cell voltage of the first power generation module is higher than the preset first voltage. This arrangement does not require any additional functional block to determine whether the cell voltage is not higher than the preset first voltage and simplifies the structures of the current regulation circuit and the current controller, thus saving the manufacturing cost of the fuel cell system.

[Aspect 5] In the fuel cell system described in the aspect 4, each of the power generation modules has a pair of separators and a membrane electrode assembly interposed between the pair of separators, and the current regulation circuit and the current controller are placed on a circumference of the membrane electrode assembly and are interposed between the pair of separators.

In the fuel cell system of the aspect 5, the current regulation circuit and the current controller are incorporated in each of the power generation modules. This preferably simplifies the structure of the fuel cell stack and enables size reduction of the overall fuel cell system. The current regulation circuit and the current controller are produced simultaneously in the manufacturing process of the membrane electrode assemblies. This simplifies the manufacturing procedure of the fuel cell stack.

[Aspect 6] In the fuel cell system described in either one of the aspect 4 and 5, the diode is a silicon diode or a Schottky barrier diode.

The fuel cell system of the aspect 6 uses the diode having a relatively low forward voltage drop. The amount of electric current flowing in the first direction can thus be increased in a relatively short time period since a decrease of the inter-power generation module voltage to a negative voltage. Compared with structures using other diodes, the structure of this aspect more effectively prevents or at least restricts catalyst deterioration. Especially the silicon diode has a high resistance to a voltage in a reverse direction, so that there is substantially no electric current flowing in the second direction in the normal power generation condition of the first power generation module. Namely this arrangement prevents the electric current from flowing in the current regulation circuit in the normal power generation condition to consume the electromotive force induced in the first power generation module as heat in the current regulation circuit, thus preventing or at least restricting reduction of the power generation efficiency.

The technique of the invention is not restricted to the fuel cell system having any of the configurations and arrangements discussed above but may be actualized by diversity of other aspects, for example, a method of controlling electric current, a computer program for controlling electric current, and a recording medium in which such a computer program is recorded.

### BRIEF DESCRIPTION OF THE DRAWINGS

Fig. 1 is an explanatory diagrammatic representation of the general configuration of a fuel cell system according to one embodiment of the invention;
Fig. 2 is an explanatory diagrammatic representation of the detailed structure of the unit cells and the current regulator shown in Fig. 1;
Fig. 3 is an explanatory diagrammatic representation of a variation of voltages of unit cells;
Fig. 4 is a flowchart showing a processing flow of current regulation process performed in the first embodiment;
Fig. 5 is an explanatory diagrammatic representation of electric current flowing in the variable resistance in the normal condition;
Fig. 6 is an explanatory diagrammatic representation of electric current flowing in the variable resistance in the hydrogen deficient condition;
Fig. 7 is an explanatory diagrammatic representation of the detailed structure of unit cells and a current regulator according to a second embodiment;
Fig. 8 is an explanatory diagrammatic representation of a processing flow of current regulation process performed in the second embodiment;
Fig. 9 is an explanatory diagrammatic representation of the general configuration of a fuel cell system according to a third embodiment;
Fig. 10 is an explanatory diagrammatic representation of the detailed structure of unit cells and the current regulator in the third embodiment;
Fig. 11 is an explanatory diagrammatic representation of electric current flowing in the diode in the normal condition of the third embodiment;
Fig. 12 is an explanatory diagrammatic representation of electric current flowing in the diode in the hydrogen deficient condition of the third embodiment;
Fig. 13 is an explanatory diagrammatic representation of the detailed structure of unit cells and a current regulator according to a fourth embodiment;
Fig. 14 is an explanatory diagrammatic representation of a processing flow of current regulation process performed in the fourth embodiment;
Fig. 15 is an explanatory diagrammatic representation of the detailed structure of unit cells and a current regulator according to a fifth embodiment; and
Fig. 16 is an explanatory diagrammatic representation of the detailed structure of unit cells and a current regulator according to a sixth embodiment.

### DESCRIPTION OF THE PREFERRED EMBODIMENT

### A. First Embodiment:

### A. System Configuration:

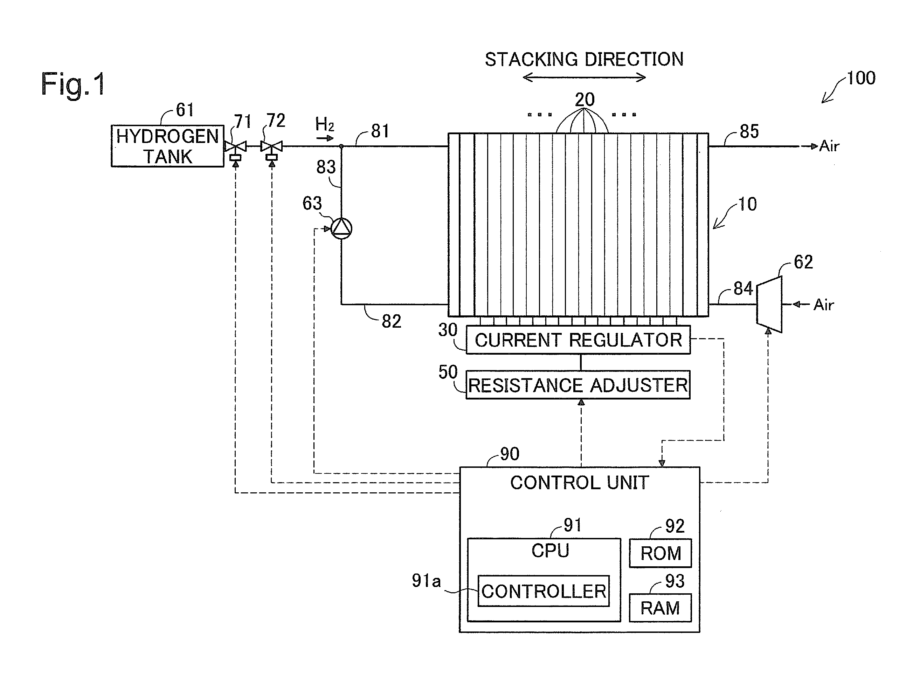

Fig. 1 is an explanatory diagrammatic representation of the general configuration of a fuel cell system according to one embodiment of the invention. In this embodiment, a fuel cell system 100 is mounted, as a driving power supply system, on an electric vehicle. The fuel cell system 100 includes a fuel cell stack 10, a hydrogen tank 61, an air compressor 62, a shutoff valve 71, a pressure regulator 72, a fuel gas supply path 81, a fuel gas discharge path 82, a bypass flow path 83, a circulation pump 63, an oxidizing gas supply path 84, an oxidizing gas discharge path 85, a current regulator 30, a resistance adjuster 50, and a control unit 90.

The fuel cell stack 10 is constructed as a stack of multiple unit cells 20 (power generation modules), which are relatively small-sized polymer electrolyte fuel cells with excellent power generation efficiency. The fuel cell stack 10 induces an electromotive force through electrochemical reactions of pure hydrogen as a fuel gas with oxygen in the air as an oxidizing gas proceeding at respective electrodes.

The hydrogen tank 61 stores high-pressure hydrogen gas. The hydrogen tank 61 may be, for example, a tank filled with a hydrogen-absorbing alloy to absorb and thereby store hydrogen. The air compressor 62 is located in the oxidizing gas supply path 84 to compress the externally intake air and supply the compressed air to the fuel cell stack 10.

The shutoff valve 71 is located at a hydrogen gas outlet (not shown) of the hydrogen tank 61 to start and stop a supply of hydrogen gas. The pressure regulator 72 is located in the fuel gas supply path 81 to lower the pressure of the high-pressure hydrogen gas supplied from the hydrogen tank 61 to a preset pressure level.

The fuel gas supply path 81 is arranged as a flow passage to connect the hydrogen tank 61 to the fuel cell stack 10 and introduce the hydrogen gas supplied from the hydrogen tank 61 to the fuel cell stack 10. The fuel gas discharge path 82 is arranged as a flow passage to discharge excess hydrogen gas (anode off-gas) from the fuel cell stack 10. The bypass flow path 83 is arranged to connect the fuel gas supply path 81 to the fuel gas discharge path 82 and introduce the excess hydrogen gas discharged from the fuel gas discharge path 82 to the fuel gas supply path 81 in a normal operating condition. The circulation pump 63 is provided on the bypass flow path 83 to recirculate the excess hydrogen gas (anode off-gas) from the fuel gas discharge path 82 to the fuel gas supply path 81.

The oxidizing gas supply path 84 is arranged as a flow passage to connect the air compressor 62 to the fuel cell stack 10 and introduce the compressed air supplied from the air compressor 62 to the fuel cell stack 10. The oxidizing gas discharge path 85 is arranged as a flow passage to discharge the excess air (cathode off-gas) and generated water from the fuel cell stack 10 to the outside (atmosphere).

The current regulator 30 is connected to the respective unit cells 20. The detailed structure of the current regulator 30 is explained later. The resistance adjuster 50 is connected to the current regulator 30 to adjust a value of a resistance (not shown) included in the current regulator 30.

The control unit 90 is electrically connected with the circulation pump 63, the air compressor 62, the shutoff valve 71, the pressure regulator 72, and the resistance adjuster 50 to control these components. The control unit 90 is also connected with a current sensor (not shown) included in the current regulator 30 to receive signals representing current values notified by the current sensor.

The control unit 90 includes a CPU (Central Processing Unit) 91, a ROM (Read Only Memory) 92, and a RAM (Random Access Memory) 93. The ROM 92 stores therein a control program (not shown) executed to control the operations of the fuel cell system 100. The CPU 91 loads and executes the control program on the RAM 93 to serve as a controller 91a. The controller 91a performs a current regulation process described later.

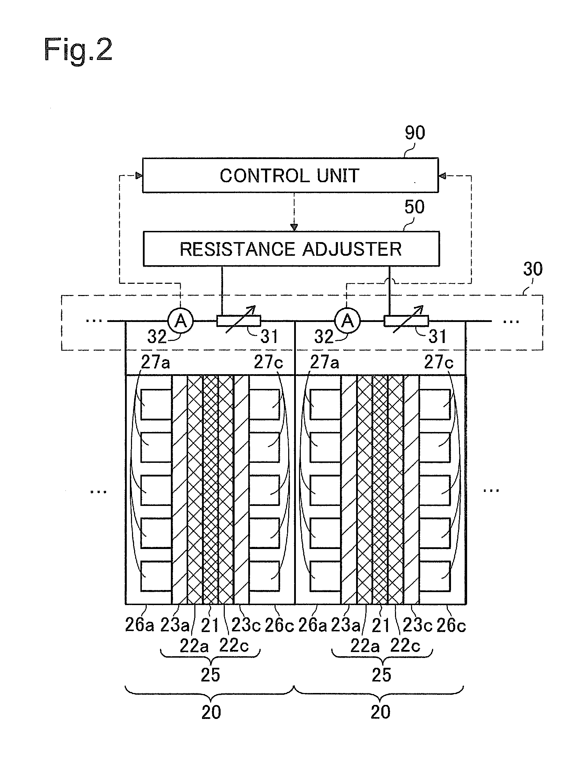

Fig. 2 is an explanatory diagrammatic representation of the detailed structure of the unit cells and the current regulator shown in Fig. 1. The unit cell 20 includes a membrane electrode assembly 25, a cathode-side separator 26c, and an anode-side separator 26a. The membrane electrode assembly 25 includes an electrolyte membrane 21, a cathode catalyst layer 22c, a cathode gas diffusion layer 23c, an anode catalyst layer 22a, and an anode gas diffusion layer 23a.

The electrolyte membrane 21 is implemented by a sulfonate group-containing fluororesin ion exchange membrane and may be made of, for example, Flemion (registered trademark) or Aciplex (registered trademark). Alternatively the electrolyte membrane 21 may be implemented by another ion exchange group-containing membrane, such as a phosphate group or a carboxylic group instead of sulfonate group.

The cathode catalyst layer 22c is placed in contact with the electrolyte membrane 21. The cathode catalyst layer 22c is composed of a a material of catalyst-supported conductive particles and an ionomer as a proton conductor. Typical examples of the catalyst include platinum and platinum alloys, such as platinum-ruthenium and platinum-iron. Typical examples of the conductive particles include carbon particles, such as carbon black, and carbon fibers. A typical example of the ionomer is a sulfonate group-containing fluororesin.

The cathode gas diffusion layer 23c is composed of a porous material to diffuse the air used as a reaction gas and discharge the water produced through the electrochemical reactions or by any other reasons. More specifically, the cathode gas diffusion layer 23c may be made of a carbon porous material, such as carbon paper or carbon cloth, or a metal porous material, such as metal mesh or foamed metal.

The cathode-side separator 26c is made of a gas-impermeable conductive material, for example, gas-impermeable dense carbon formed by compression of carbon or a press-formed metal plate. The cathode-side separator 26c is formed to have concavities and convexes, such that an oxidizing gas flow path 27c is formed between the cathode-side separator 26c and the cathode gas diffusion layer 23c that is placed in contact with the cathode-side separator 26c. The oxidizing gas flow path 27c serves to introduce the air supplied from the air compressor 62 to the cathode gas diffusion layer 23c and discharge off-gases (the excess air and water vapor) from the cathode diffusion layer 23c to the outside of the unit cell 20.

The anode-side structure is similar to the cathode-side structure described above. The anode catalyst layer 22a has the same structure as that of the cathode catalyst layer 22c. The anode gas diffusion layer 23a and the anode-side separator 26a respectively have the same structures as those of the cathode gas diffusion layer 23c and the cathode-side separator 26c. A fuel gas flow path 27a formed between the anode-side separator 26a and the anode gas diffusion layer 23a serves to introduce the hydrogen gas supplied from the hydrogen tank 62 or by the circulation pump 63 to the anode gas diffusion layer 23a and discharge an off-gas (excess hydrogen gas) from the anode gas diffusion layer 23a to the outside of the unit cell 20.

The current regulator 30 includes a plurality of variable resistances 31 connected in parallel to the respective unit cells 20 and a plurality of current sensors 32 connected in series with the respective variable resistances 31. The resistance value of each of the variable resistances 31 is adjusted by the resistance adjuster 50. Each of the current sensors 32 detects a value of electric current flowing in the corresponding variable resistance 31 and notifies the control unit 90 of the detected current value. The control unit 90 (controller 91a) identifies a direction of electric current flowing in the variable resistance 31, based on the sign (positive or negative) of the received current value.

A specific structure discussed below may be adopted for the current regulator 30 and the resistance adjuster 50. Each of the variable resistances 31 may be designed to include a plurality of resistances having a plurality of resistance values and being connectable in parallel to the unit cell 20. The resistance adjuster 50 is implemented as switches connected to the respective resistances in series. The resistance value of the variable resistance 31 is adjustable by varying the number of the resistances connected (in parallel) to the unit cell 20.

The unit cell 20 described above corresponds to the power generation module in the claims of the invention. The membrane electrode assembly 25, the anode-side separator 26a, the cathode-side separator 26c, and the variable resistance 31 respectively correspond to the power generation assembly, the anode-side non-power generation structure, the cathode-side non-power generation structure, and the current regulation circuit in the claims of the invention. The combination of the resistance adjuster 50, the current sensor 32, and the controller 91a is equivalent to the current controller in the claims of the invention. The current sensor 32 corresponds to the electric current direction detector in the claims of the invention. In another aspect of the invention, the electrolyte membrane 21, the anode catalyst layer 22a, and the cathode catalyst layer 22c of the membrane electrode assembly 25 correspond to the power generation assembly in the claims of the invention. The anode-side separator 26a, the cathode-side separator 26c, the anode gas diffusion layer 23a, and the cathode gas diffusion layer 23c correspond to the non-power generation structure in the claims of the invention.

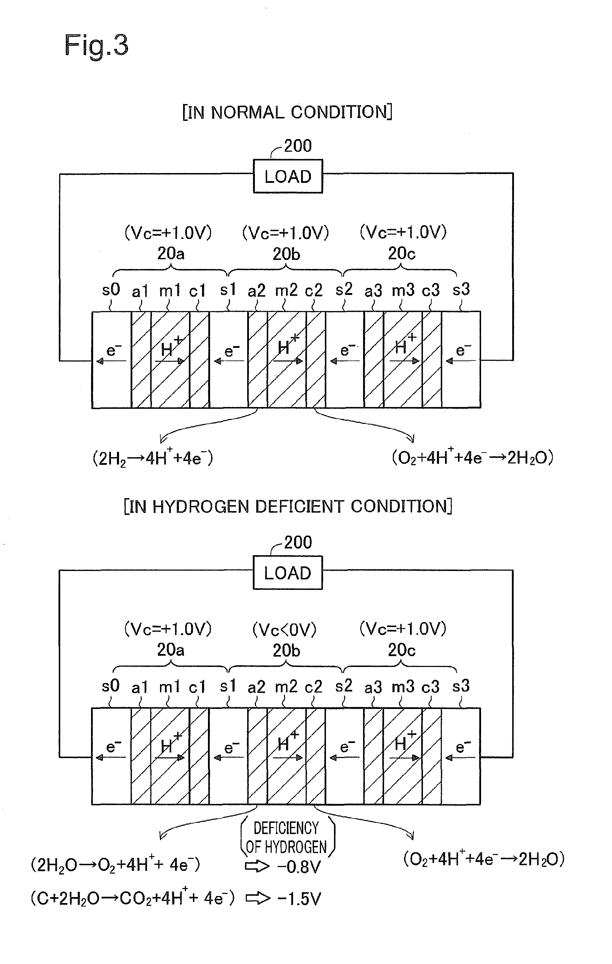

Fig. 3 is an explanatory diagrammatic representation of a variation of voltages of unit cells. The upper drawing of Fig. 3 shows voltages of the unit cells 20 in a normal condition, and the lower drawing of Fig. 3 shows voltages of the unit cells 20 in a hydrogen deficient condition.

For the convenience of explanation, the fuel cell stack 10 is illustrated in Fig. 3 as a stack of three unit cells 20 (20a, 20b, and 20c). Each of the unit cells 20a, 20b, and 20c is defined by a combination of an electrolyte membrane, a cathode, an anode, and separators. More specifically, the unit cell 20a is defined by part of a separator s0, an anode a1, an electrolyte membrane m1, a cathode c1, and part of a separator s1. The separator s0 represents the anode-side separator 26a and the cathode-side separator 26c shown in Fig. 2. The anode a1 represents the anode gas diffusion layer 23a and the anode catalyst layer 22a shown in Fig. 2. The electrolyte membrane m1 represents the electrolyte membrane 21 shown in Fig. 2. The cathode c1 represents the cathode catalyst layer 22c and the cathode gas diffusion layer 23c shown in Fig. 2. The separator s1 represents the anode-side separator 26a and the cathode-side separator 26c shown in Fig. 2.

Similarly, the unit cell 20b is defined by part of the separator s1, an anode a2, an electrolyte membrane m2, a cathode c2, and part of a separator s2. The unit cell 20c is defined by part of the separator s2, an anode a3, an electrolyte membrane m3, a cathode c3, and part of a separator s3.

As shown in the upper drawing of Fig. 3, in the normal condition that the respective unit cells 20a, 20b, and 20c receive sufficient supplies of hydrogen gas and the air and generate electric power, a reaction expressed by Equation 1 given below proceeds on the anode, while a reaction expressed by Equation 2 given below proceeds on the cathode. In this condition, each of the unit cells 20a, 20b, and 20c has a voltage (inter-separator voltage in each unit cell: cell voltage Vc) approximately equal to +1.0 V. The reactions of Equations 1 and 2 proceed when the voltages of the respective unit cells 20a, 20b, and 20c are higher than 0 V.

2H₂ → 4H⁺ + 4e⁻ (1)

O₂ + 4H⁺ + 4e⁻ → 2H₂O (2)

The cell voltage Vc is defined by Equation 3. In Equation 3, Vc, Ec, and Ea respectively denote a cell voltage, a cathode potential, and an anode potential and IR represents a voltage drop due to a resistance of the unit cell (e.g., a resistance of the electrolyte membrane and a contact resistance of wiring). The cell voltage Vc means an inter-unit cell voltage. For example, the cell voltage Vc of the unit cell 20b means a voltage between the unit cell 20a (cathode c1) and the unit cell 20c (anode a3).

Vc = Ec - Ea - IR (3)

In the condition that a supply of hydrogen gas to a unit cell is less than an amount required for power generation (in the hydrogen deficient condition), an increase in anode potential Ea may make the cell voltage Vc negative in Equation 3 given above. The hydrogen deficiency may occur when water produced through the electrochemical reactions (produced water) is accumulated in the fuel gas flow path 27a to increase a pressure loss in the fuel gas flow passage or when the produced water accumulated in, for example, the anode gas diffusion layer 23a is frozen in a sub-zero environment to deteriorate the gas diffusion performance.

In the state shown in the lower drawing of Fig. 3, the unit cell 20b has hydrogen deficiency and a negative value of the cell voltage Vc. While the other unit cells 20a and 20c normally generate electric power, the unit cell 20b tries to generate electric current (i.e., tries to transmit electrons). Due to the hydrogen deficiency, however, the reactions of Equations 1 and 2 given above are inhibited in the unit cell 20b, but reactions expressed by Equations 4 and 5 proceed at the anode a2. The reaction of Equation 4 proceeds when the cell voltage Vc is not higher than approximately -0.8 V. The reaction of Equation 5 proceeds when the cell voltage Vc is not higher than approximately -1.5 V. The reaction of Equation 6 given below proceeds at the cathode c2.

2H₂O → O₂ + 4H⁺ + 4e⁻ (4)

C + 2H₂O → CO₂ + 4H⁺ + 4e⁻ (5)

The reaction of Equation 5 implies oxidation of carbon included in the catalyst of the anode a2. Namely there is a possibility of catalyst deterioration at the anode a2 due to the reaction of Equation 5 in the hydrogen deficient condition. The fuel cell system 100 of this embodiment performs a current regulation process described below to prevent or at least restrict catalyst deterioration accompanied with the hydrogen deficiency.

### A2. Current Regulation Process

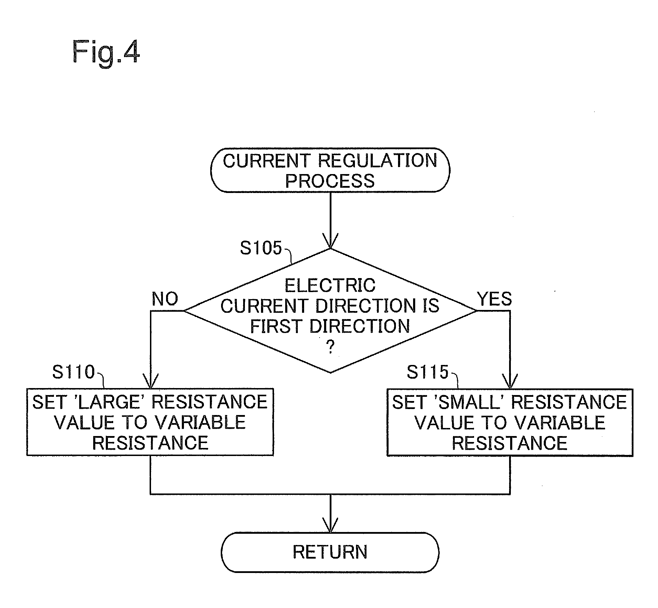

Fig. 4 is a flowchart showing a processing flow of current regulation process performed in the first embodiment. In the fuel cell system 100, the current regulation process is triggered by a start of the fuel cell system 100. The controller 91a shown in Fig. 1 identifies whether the direction of electric current in the variable resistance 31 is a first direction, based on the current value of each unit cell 20 notified by the corresponding current sensor 32 (step S105).

When it is identified that the direction of electric current is not the first direction (but a second direction opposite to the first direction), the controller 91a controls the resistance adjuster 50 to set a predetermined large value to the resistance value of the variable resistance 31 corresponding to the unit cell 20 (step S 110) and returns the processing flow to step S105. With it is identified that the direction of electric current is the first direction, on the other hand, the controller 91a controls the resistance adjuster 50 to set a predetermined small value to the resistance value of the variable resistance 31 corresponding to the unit cell 20 (step S115) and returns the processing flow to step S105.

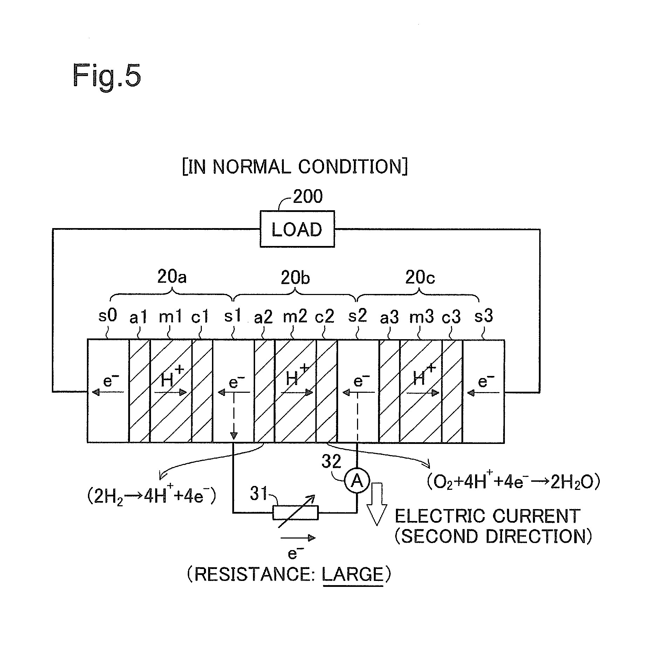

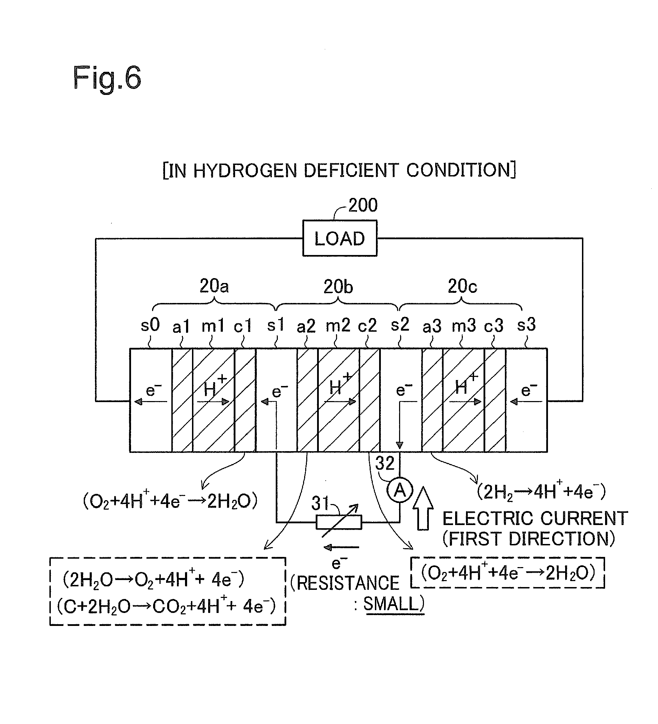

Fig. 5 is an explanatory diagrammatic representation of electric current flowing in the variable resistance in the normal condition. Fig. 6 is an explanatory diagrammatic representation of electric current flowing in the variable resistance in the hydrogen deficient condition. The respective unit cells 20a, 20b, and 20c shown in Figs. 5 and 6 are identical with the unit cells 20a, 20b, and 20c explained above with reference to Fig. 3. For the convenience of explanation, only the variable resistance 31 corresponding to the unit cell 20b is illustrated in Figs. 5 and 6.

In the normal condition (having the cell voltage Vc of higher than 0 V), the reaction of Equation 1 given above proceeds at the anode a2 of the respective unit cells 20a, 20b, and 20c, while the reaction of Equation 2 given above proceeds at the cathode c2. In this state, electrons flow in the variable resistance 31 in a direction from the separator s1 (the anode-side separator 26a of the unit cell 20b) to the separator s2 (the cathode-side separator 26c of the unit cell 20b) as shown in Fig. 5. Namely the electric current flows in the variable resistance 31 in a direction from the separator s2 (the cathode-side separator 26c of the unit cell 20b) to the separator s1 (the anode-side separator 26a of the unit cell 20b). In this embodiment, this direction (from the separator s2 to the separator s1) is specified as the second direction, and the opposite direction (from the separator s1 to the separator s2) is specified as the first direction. In the normal condition, the direction of electric current in the variable resistance 31 is the second direction, so that the processing flow goes to step S110 to set a large value to the resistance value of the variable resistance 31. Such setting restricts the amount of electric current flowing in the variable resistance 31 in the second direction.

Setting a large value to the resistance value of the variable resistance 31 in the normal condition is ascribed to the following reason. An increase of the amount of electric current flowing in the variable resistance 31 increases the amount of electric power consumed as heat in the variable resistance 31, out of the electromotive force induced in the unit cell 20. This lowers the power generation efficiency of the unit cell 20. The fuel cell system 100 sets a large value to the resistance value of the variable resistance 31 in the normal condition to decrease the amount of electric current flowing in the second direction and thereby reduce the amount of electric power consumed as heat in the variable resistance 31, thus enhancing the power generation efficiency of the unit cell 20.

In the hydrogen deficient condition of the unit cell 20b, the cell voltage Vc of the unit cell 20b decreases to a negative voltage, so that the reaction of Equation 1 given above is inhibited in the unit cell 20b. There is accordingly no supply of electrons from the anode a2 of the unit cell 20b to the cathode c1 of the unit cell 20a. In this state, electrons generated through the reaction of Equation 1 at the anode a3 of the unit cell 20c are supplied to the cathode c1 of the unit cell 20a via the variable resistance 31 as shown in Fig. 6. In the hydrogen deficient condition, the direction of electric current in the variable resistance 31 is accordingly the first direction, so that the processing flow goes to step S115 to set a small value to the resistance value of the variable resistance 31, so as to increase the amount of electric current flowing in the variable resistance 31. This leads to supply of electrons to the cathode c1 of the unit cell 20a. Such electron supply inhibits the reactions of Equations 4 and 5 in the unit cell 20b in the hydrogen deficient condition. This prevents or at least restricts catalyst deterioration at the anode a2.

As described above, when the cell voltage Vc is higher than 0 V, the reactions of Equations 1 and 2 given above proceed in each unit cell 20 to make the electric current flow in the second direction. The voltage '0 V' of this embodiment corresponds to the preset first voltage in the claims of the invention. The unit cell 20b, the unit cell 20a, and the unit cell 20c respectively correspond to the first power generation module, the second power generation module, and the third power generation module in the claims of the invention.

As described above, when the direction of electric current in the variable resistance 31 is the first direction (i.e., when the cell voltage Vc of the unit cell 20 is a negative voltage), the fuel cell system 100 of the first embodiment lowers the resistance value of the variable resistance 31 connected in parallel to the unit cell 20. The lowered resistance value increases the amount of electric current flowing in the variable resistance 31 and prevents or at least restricts oxidation of carbon in the unit cell 20. This prevents or at least restricts catalyst deterioration in the unit cell 20 having a negative voltage. When the cell voltage Vc is not a negative voltage, the fuel cell system 100 of the first embodiment increases the resistance value of the variable resistance 31 to decrease the amount of electric current flowing in the variable resistance 31, thus enhancing the power generation efficiency of the unit cell 20.

The setting of the resistance value of the variable resistance 31 is changed over, based on the identified direction of electric current flowing in the variable resistance 31 (step S105). This arrangement assures accurate detection of the state in which the chemical reactions in the normal condition (i.e., the reactions of Equations 1 and 2 given above) are inhibited in the unit cell 20b but the chemical reactions accompanied with generation of electrons tend to proceed at the anode a2.

### B. Second Embodiment

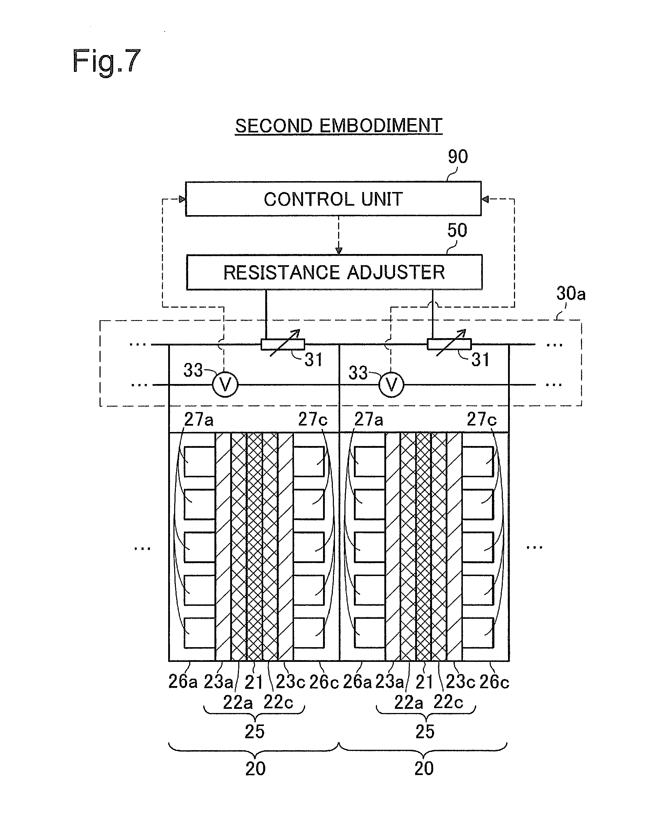

Fig. 7 is an explanatory diagrammatic representation of the detailed structure of unit cells and a current regulator according to a second embodiment. Unlike the fuel cell system 100 of the first embodiment, a fuel cell system of the second embodiment has a current regulator 30a including voltage sensors 33, in place of the current sensors 32, and uses the cell voltage Vc as the criterion for changing over the setting of the resistance value of the variable resistance 31. Otherwise the configuration of the fuel cell system of the second embodiment is similar to the configuration of the fuel cell system 100 of the first embodiment. The unit cells 20 of the second embodiment have the same structure as that of the first embodiment.

As shown in Fig. 7, the current regulator 30a of the second embodiment has the voltage sensors 33 connected in parallel to the respective unit cells 20. The voltage sensor 33 measures the cell voltage Vc and notifies the control unit 90 (controller 91a) of the measured cell voltage Vc.

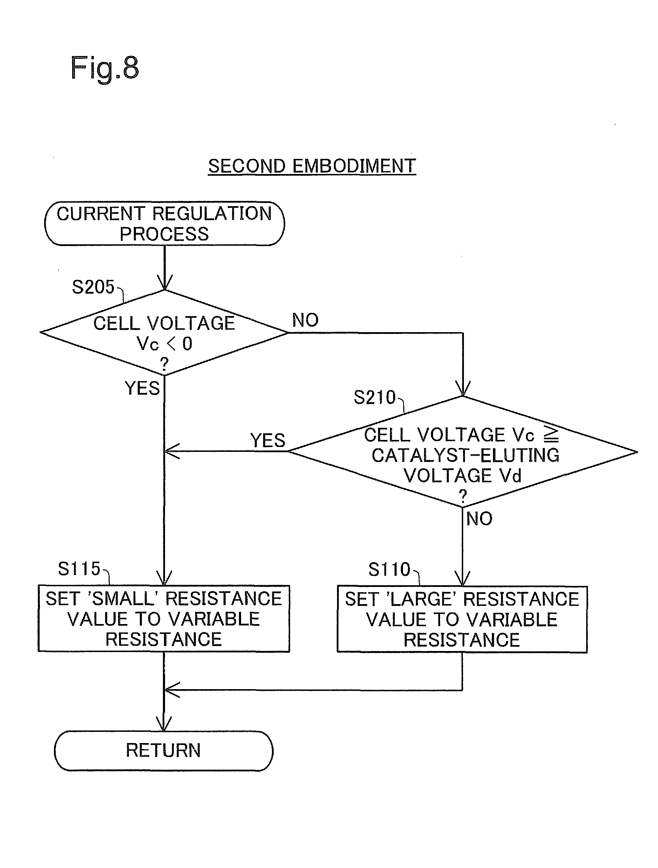

Fig. 8 is an explanatory diagrammatic representation of a processing flow of current regulation process performed in the second embodiment. The controller 91a determines whether the cell voltage Vc notified by the voltage sensor 33 is a negative voltage (step S205). Upon determination that the cell voltage Vc is a negative voltage (step S205: Yes), the controller 91a performs the processing of step S115 explained above (i.e., setting a small value to the resistance value of the variable resistance 31) and returns to step S205.

Upon determination that the cell voltage Vc is not a negative voltage at step S205, the controller 91a subsequently determines whether the cell voltage Vc is equal to or higher than a catalyst-eluting voltage Vd (step S210). The catalyst-eluting voltage Vd is, for example, 0.85V for platinum (Pt) as the catalyst. In a state where platinum is used as the catalyst and the cell voltage Vc reaches or exceeds 0.85V (e.g., in an OC (Open Circuit) state after an operation stop of the fuel cell system 100), platinum ionization occurs to cause catalyst deterioration. The catalyst-eluting voltage Vd corresponds to the preset second voltage in the claims of the invention.

Upon determination that the cell voltage Vc is lower than the catalyst-eluting voltage Vd (step S210: No), the controller 91a performs the processing of step S110 explained above (i.e., setting a large value to the resistance value of the variable resistance 31) and returns to step S205. Upon determination that the cell voltage Vc is equal to or higher than the catalyst-eluting voltage Vd (step S210: Yes), on the other hand, the controller 91a performs the processing of step S115 explained above (i.e., setting a small value to the resistance value of the variable resistance 31) and returns to step S205.

The fuel cell system of the second embodiment with the arrangement described above has the similar effects to those of the fuel cell system 100 of the first embodiment. When the cell voltage Vc reaches or exceeds the catalyst-eluting voltage Vd, the fuel cell system of the second embodiment sets a small value to the resistance value of the variable resistance 31 so as to increase the amount of electric current flowing in the variable resistance 31. The increased amount of electric current enables a greater amount of the electromotive force induced in the unit cell 20 to be consumed as heat in the variable resistance 31. This lowers the voltage of the unit cell 20 and thereby prevents or at least restricts elution of the catalyst at the anode.

### C. Third Embodiment

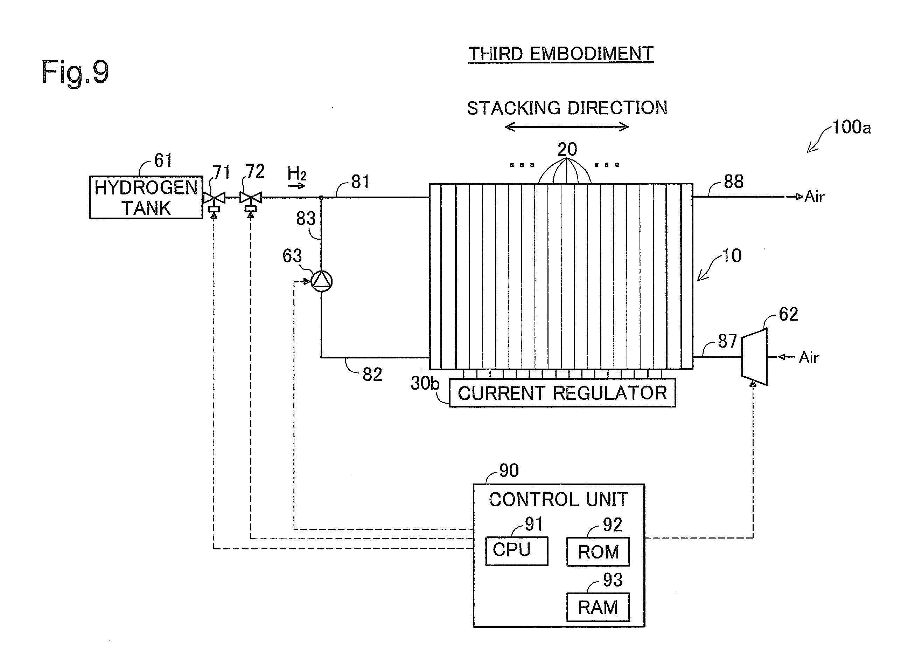

Fig. 9 is an explanatory diagrammatic representation of the general configuration of a fuel cell system according to a third embodiment. A fuel cell system 100a of the third embodiment has a similar configuration to that of the fuel cell system 100 of the first embodiment, except omission of the resistance adjuster 50 and the controller 91a and replacement of the current regulator 30 with a current regulator 30b.

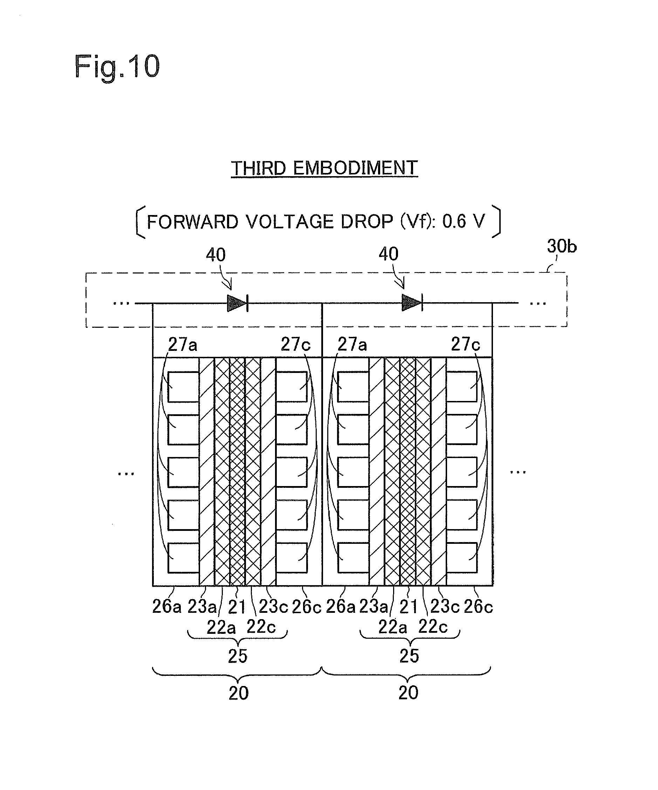

Fig. 10 is an explanatory diagrammatic representation of the detailed structure of unit cells and the current regulator in the third embodiment. Unlike the current regulator 30 of the first embodiment, the current regulator 30b of the third embodiment has diodes 40 connected to the respective unit cells 20, in place of the variable resistances 31 and the current sensors 32. The unit cells 20 of the third embodiment have the same structure as that of the first embodiment.

As shown in Fig. 10, the current regulator 30b of the third embodiment has the diodes 40 connected in parallel to the respective unit cells 20. The diode 40 has a P-side connected to the anode of the unit cell 20 and an N-side connected to the cathode of the unit cell 20. Silicon diodes are used for the diodes 40 of the third embodiment. The silicon diode has a forward voltage drop Vf of about 0.6 V and a large resistance to a reverse voltage.

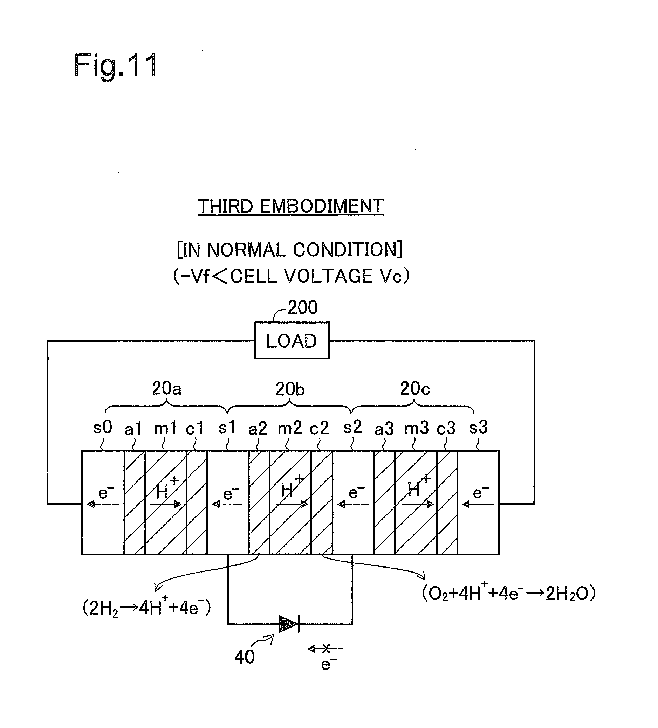

Fig. 11 is an explanatory diagrammatic representation of electric current flowing in the diode in the normal condition of the third embodiment. In the normal condition of the first embodiment, electrons flow in the direction from the anode a2 of the unit cell 20b to the cathode c2 of the unit cell 20b, so that there is an electric current in the second direction. In the normal condition of the third embodiment, however, there is substantially no electric current flowing in the diode 40, since the electric current in the second direction corresponds to the electric current in a reverse direction in the diode 40. The state of Fig. 11 occurs in the normal condition (where the cell voltage Vc is not lower than 0 V) and in a condition that the cell voltage Vc of the unit cell 20b is a negative voltage of higher than - Vf (for example, -0.6 V).

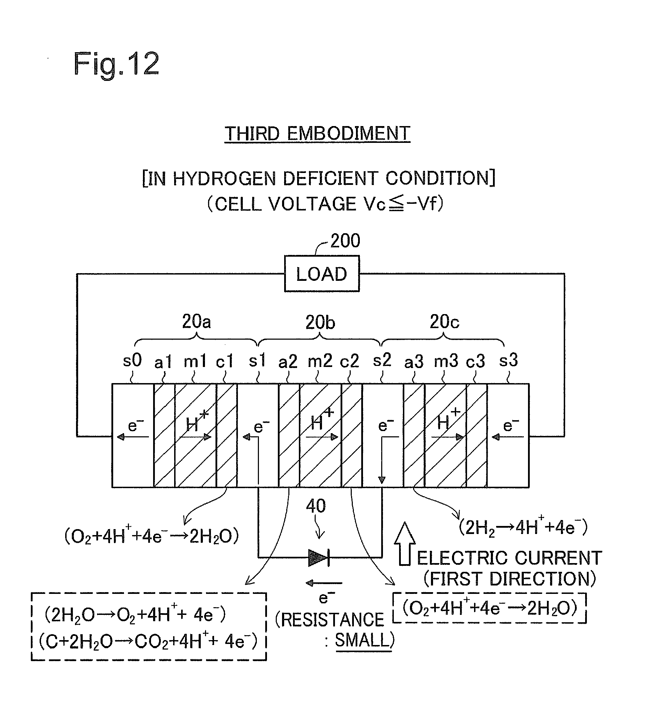

Fig. 12 is an explanatory diagrammatic representation of electric current flowing in the diode in the hydrogen deficient condition of the third embodiment. The state of Fig. 12 occurs, when the unit cell 20b has hydrogen deficiency and the cell voltage Vc of not higher than -Vf.

In the state where the unit cell 20b has hydrogen deficiency and the cell voltage Vc of the unit cell 20b is a negative voltage of not higher than -Vf, there is an electric current in a forward direction in the diode 40, i.e., the electric current in the first direction. As in the state of Fig. 6 explained in the first embodiment, electrons generated through the reaction of Equation 1 given above at the anode a3 of the unit cell 20c are supplied to the cathode c1 of the unit cell 20a via the variable resistance 31. This prevents or at least restricts catalyst deterioration at the anode a2.

As described above, in the configuration of this embodiment, there is substantially no electric current either in the first direction or in the second direction, when the cell voltage Vc of the unit cell 20 is higher than -Vc. There is an electric current in the first direction, when the cell voltage Vc of the unit cell 20 is not higher than -Vc. The voltage '-Vf of this embodiment corresponds to the preset first voltage in the claims of the invention.

The fuel cell system 100a of the third embodiment with the arrangement described above has the similar effects to those of the fuel cell system 100 of the first embodiment. The omission of the resistance adjuster 50 and the controller 91a and the simplified structure of the current regulator 30a preferably save the manufacturing cost of the fuel cell system 100a.

### D. Fourth Embodiment

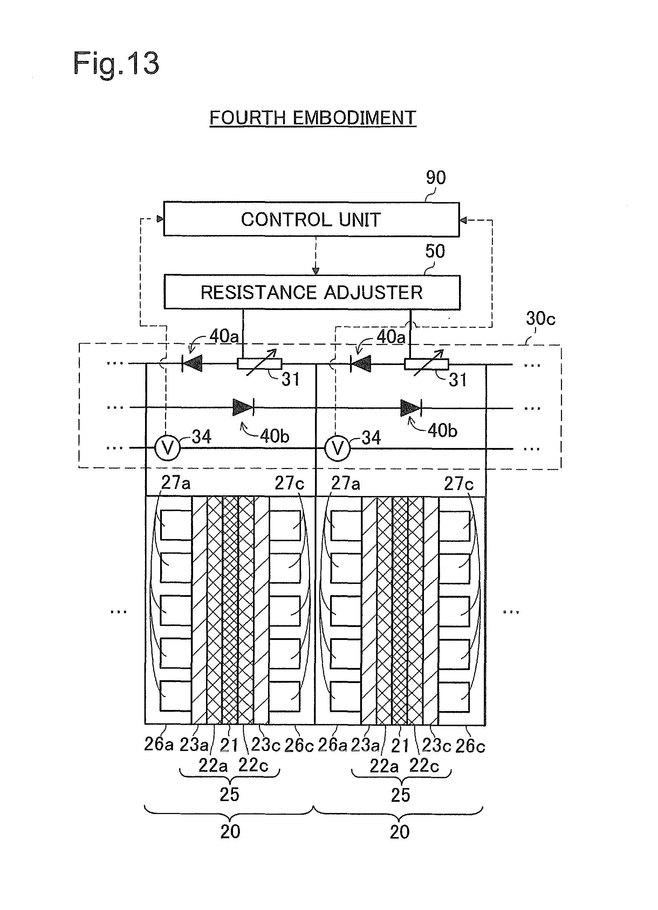

Fig. 13 is an explanatory diagrammatic representation of the detailed structure of unit cells and a current regulator according to a fourth embodiment. Unlike the fuel cell system 100 of the first embodiment, a fuel cell system of the fourth embodiment has a current regulator 30c including first diodes 40a in place of the current sensors 32 and additionally including second diodes 40b and voltage sensors 34 and uses the cell voltage Vc as the criterion for changing over the setting of the resistance value of the variable resistance 31. Otherwise the configuration of the fuel cell system of the fourth embodiment is similar to the configuration of the fuel cell system 100 of the first embodiment. The unit cells 20 of the fourth embodiment have the same structure as that of the first embodiment.

As shown in Fig. 13, the current regulator 30c of the fourth embodiment has the first diodes 40a connected in series with the variable resistances 31 corresponding to the respective unit cells 20. The first diode 40a has a P-side connected to the variable resistance 31 and an N-side connected to the anode of the unit cell 20. The current regulator 30c also has the second diodes 40b connected in parallel to the respective unit cells 20. The second diode 40b has a P-side connected to the anode of the unit cell 20 and an N-side connected to the cathode of the unit cell 20. Like the third embodiment, silicon diodes are used for both the first diodes 40a and the second diodes 40b. The current regulator 30c further has the voltage sensors 34 connected in parallel to the respective unit cells 20.

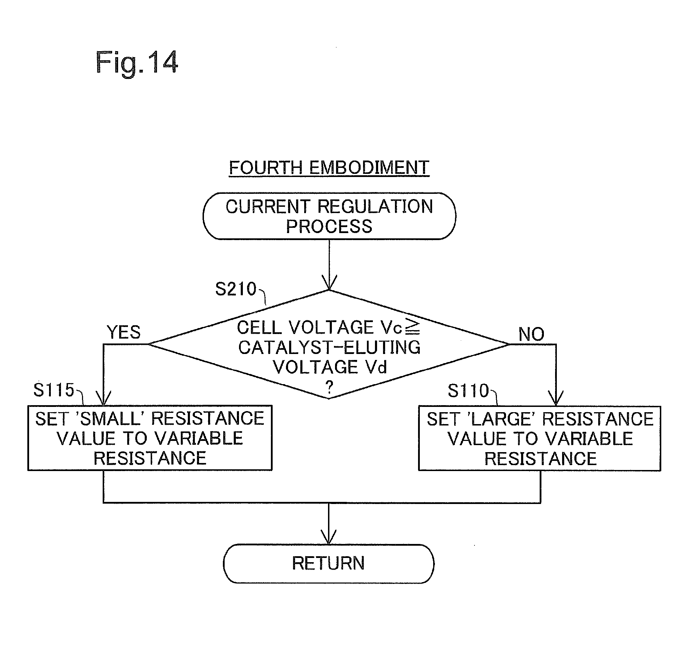

Fig. 14 is an explanatory diagrammatic representation of a processing flow of current regulation process performed in the fourth embodiment. The controller 91a determines whether the cell voltage Vc notified by the voltage sensor 34 is equal to or higher than the catalyst-eluting voltage Vd (step S210). Upon determination that the cell voltage Vc is lower than the catalyst-eluting voltage Vd (step S210: No), the controller 91a performs the processing of step S110 explained above (i.e., setting a large value to the resistance value of the variable resistance 31) and returns to step S210. Upon determination that the cell voltage Vc is equal to or higher than the catalyst-eluting voltage Vd (step S210: Yes), on the other hand, the controller 91a performs the processing of step S115 explained above (i.e., setting a small value to the resistance value of the variable resistance 31) and returns to step S210.

As in the third embodiment, in the hydrogen deficient condition of the fourth embodiment, the electric current flows in the forward direction in the second diode 40b. This prevents or at least restricts catalyst deterioration at the anode of each unit cell 20. When the cell voltage Vc is lower than the catalyst-eluting voltage Vd in the normal condition, a large value is set to the resistance value of the variable resistance 31. In this state, there is substantially no electric current flowing in the first diode 40a, as well as in the second diode 40b. This prevents or at least restricts the reduction of the power generation efficiency due to the flow of electric current in the first diode 40a and in the second diode 40b. When the cell voltage Vc is not lower than the catalyst-eluting voltage Vd in the normal condition, a small value is set to the resistance value of the variable resistance 31. In this state, the electric current flows in the first diode 40a, while there is substantially no electric current flowing in the second diode 40b. This enables a greater amount of the electromotive force induced in the unit cell 20 to be consumed as heat in the variable resistance 31 and lowers the voltage of the unit cell 20, thus preventing or at least restricting elution of the catalyst at the anode.

The fuel cell system of the fourth embodiment with the arrangement described above has the similar effects to those of the fuel cell system 100 of the first embodiment. When the cell voltage Vc reaches or exceeds the catalyst-eluting voltage Vd, the fuel cell system of the fourth embodiment sets a small value to the resistance value of the variable resistance 31 so as to increase the amount of electric current flowing in the variable resistance 31. The increased amount of electric current enables a greater amount of the electromotive force induced in the unit cell 20 to be consumed as heat in the variable resistance 31. This lowers the voltage of the unit cell 20 and thereby prevents or at least restricts elution of the catalyst at the anode. The fuel cell system of the fourth embodiment excludes the decision step of determining whether the cell voltage Vc is a negative voltage (step S205) and the processing flow to change over the setting of the resistance of the variable resistance 31 (step S 115) in the state where the cell voltage Vc is a negative voltage. This preferably simplifies the processing flow of current regulation process in the fuel cell system of the fourth embodiment, compared with the fuel cell system of the second embodiment, and saves the resources, such as the CPU 91 and the RAM 93.

### E. Fifth Embodiment

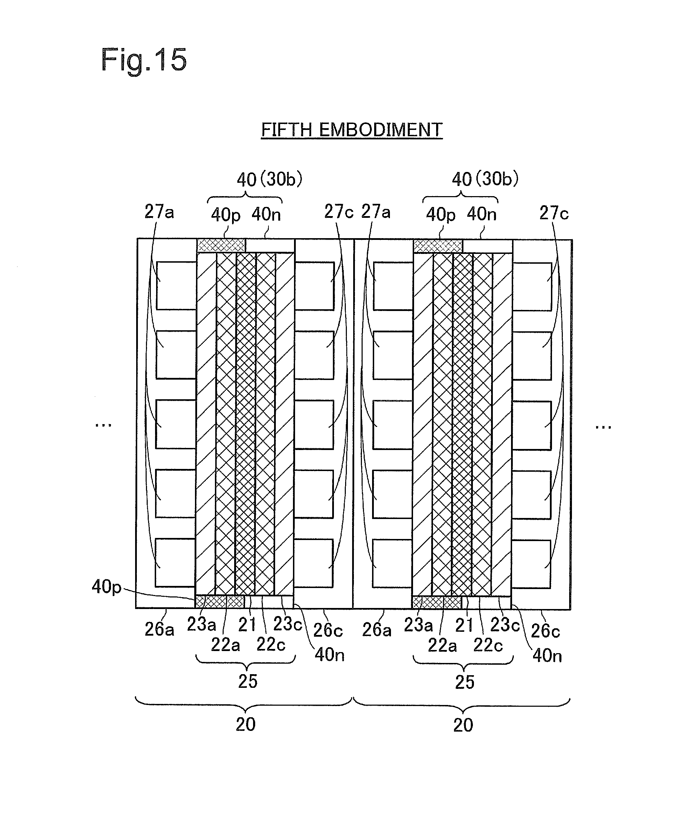

Fig. 15 is an explanatory diagrammatic representation of the detailed structure of unit cells and a current regulator according to a fifth embodiment. A fuel cell system of the fifth embodiment has a similar configuration to that of the fuel cell system 100a of the third embodiment shown in Figs. 9 to 12, except that current regulator 30b is incorporated in the respective unit cells 20.

In the configuration of the third embodiment, the current regulator 30 (diodes 40) is placed outside the respective unit cells. In the configuration of the fifth embodiment, however, the current regulator 30c (diodes 40) is placed inside the respective unit cells 20 as shown in Fig. 15.

As shown in Fig. 15, the current regulator 30b consists of only diodes 40 placed on the outer circumferences of the respective membrane electrode assemblies 25. The diode 40 includes P-type silicon 40p connected to the anode-side separator 26a and N-type silicon 40n connected to the cathode-side separator 26c. This structure may be achieved by implementing portions of seal member made of, for example, a resin and placed on the outer circumferences of the respective membrane electrode assemblies 25 as the diodes 40.

The fuel cell system of the fifth embodiment with the arrangement described above has the similar effects to those of the fuel cell system 100a of the third embodiment. In the fuel cell system of the fifth embodiment, the current regulator 30b (diodes 40) is incorporated in the respective unit cells 20. This preferably simplifies the structure of the fuel cell stack 10 and enables size reduction of the overall fuel cell system. The current regulator 30b provided on the outer circumferences of the respective membrane electrode assemblies 25 is produced simultaneously in the manufacturing process of the membrane electrode assemblies 25. This simplifies the manufacturing procedure of the fuel cell stack 10.

### F. Sixth Embodiment

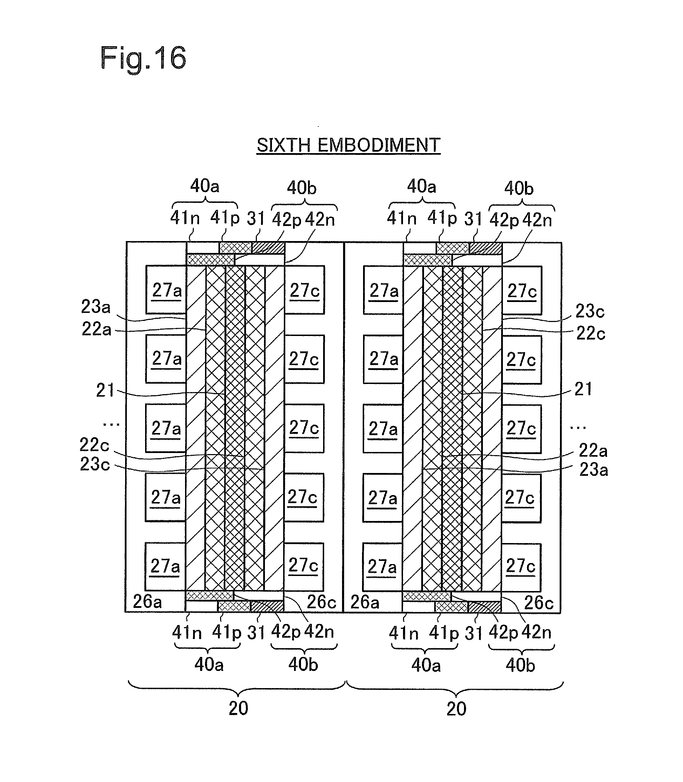

Fig. 16 is an explanatory diagrammatic representation of the detailed structure of unit cells and a current regulator according to a sixth embodiment. A fuel cell system of the sixth embodiment has a similar configuration to that of the fuel cell system of the fourth embodiment shown in Figs. 13 and 14, except that the first diodes 40a and the second diodes 40b are incorporated in the respective unit cells 20 as in the fuel cell system of the fifth embodiment.

In the configuration of the fourth embodiment, the first diodes 40a, the second diodes 40b, and the variable resistances 31 are placed outside the respective unit cells. In the configuration of the sixth embodiment, however, the first diodes 40a, the second diodes 40b, and the variable resistances 31 are placed inside the respective unit cells 20 as shown in Fig. 16.

As shown in Fig. 16, the first diode 40a includes P-type silicon 41p connected to the variable resistance 31 and N-type silicon 41n connected to the anode-side separator 26a. The variable resistance 31 is placed in contact with the cathode-side separator 26c.

The second diode 40b includes P-type silicon 42p connected to the anode-side separator 26a and N-type silicon 42n connected to the cathode-side silicon 26c.

As in the fifth embodiment, this structure of the sixth embodiment may be achieved by implementing portions of seal member made of, for example, a resin and placed on the outer circumferences of the respective membrane electrode assemblies 25 as the first diodes 40a, the second diodes 40b, and the variable resistances 31.

The fuel cell system of the sixth embodiment with the arrangement described above has the similar effects to those of the fuel cell system of the fourth embodiment. In the fuel cell system of the sixth embodiment, the first diodes 40a, the second diodes 40b, and the variable resistances 31 are incorporated in the respective unit cells 20. This preferably simplifies the structure of the fuel cell stack and enables size reduction of the overall fuel cell system. The current regulator 30b provided on the outer circumferences of the respective membrane electrode assemblies 25 is produced simultaneously in the manufacturing process of the membrane electrode assemblies 25. This simplifies the manufacturing procedure of the fuel cell stack 10.

### G. Modifications:

Among the various constituents and components included in the respective embodiments discussed above, those other than the constituents and components disclosed in independent claims are additional and supplementary elements and may be omitted according to the requirements. The invention is not limited to any of the embodiments and their aspects discussed above but may be actualized in diversity of other embodiments and aspects within the scope of the invention. Some examples of possible modification are given below.

### G1. Modification 1:

The silicon diodes are used as the diodes in the third through the sixth embodiments. The technique of the invention is, however, not restricted to the silicon diodes but may be applicable to diversity of other diodes, such as germanium diodes and Schottky barrier diodes. There is a lower level of the forward voltage drop Vf in the application with germanium diodes or Schottky barrier diodes. The amount of electric current flowing in the first direction can thus be increased in a relatively short time period since a decrease of the cell voltage Vc of the unit cell 20 to a negative voltage. This arrangement more effectively prevents or at least restricts catalyst deterioration. In the application with Schottky barrier diodes, each Schottky barrier diode may be provided as a joint body of a separator and a semiconductor layer. For example, the Schottky barrier diode may be manufactured by forming a semiconductor layer on a separator by the sputtering method.

### G2. Modification 2:

The first embodiment uses only the direction of electric current flowing in the variable resistance 31 as the criterion for changing over the setting of the resistance value of the variable resistance 31. The second embodiment uses only the cell voltage Vc as the criterion for changing over the setting of the resistance value of the variable resistance 31. The present invention is, however, not restricted to these configurations. One modification may use the direction of electric current flowing in the variable resistance 31 as a criterion for changing over the resistance value of the variable resistance 31 from a small value to a large value and use the cell voltage Vc as a criterion for changing over the resistance value of the variable resistance 31 from a large value to a small value. A modified procedure of current regulation process first determines whether the cell voltage Vc is not lower than 0 V. When the cell voltage Vc is a negative voltage (lower than 0 V), the modified procedure sets a small value to the resistance value of the variable resistance 31. After setting the small value to the resistance value of the variable resistance 31, the modified procedure monitors the direction of electric current flowing in the variable resistance 31 and, when the hydrogen deficiency is eliminated to change the direction of electric current to the second direction, sets a large value to the resistance value of the variable resistance 31. When the cell voltage Vc is not lower than 0 V, the modified procedure monitors a variation in cell voltage Vc and, when the cell voltage Vc reaches or exceeds the catalyst-eluting voltage Vd, changes over the setting of the resistance value of the variable resistance 31 from the large value to the small value.

### G3. Modification 3:

In the second embodiment, '0 V' is used as the criterion voltage at step S205 in the current regulation process. The criterion voltage is, however, not restricted to '0 V' but may be any other suitable value, for example, -0.8 V or -1.5 V In the application with the criterion voltage of -0.8 V or -1.5 V, the reaction of Equation 5 is inhibited, while the reaction of Equation 4 proceeds. This arrangement also prevents or at least restricts oxidation of carbon at the anode, thus preventing or at least restricting the reduction of the power generation efficiency of the unit cell 20. The voltage '-0.8 V' or '-1.5 V' of this modification corresponds to the preset first voltage in the claims of the invention.

### G4. Modification 4:

In the respective embodiments discussed above, the membrane electrode assembly 25 has the MEGA (Membrane Electrode and Gas Diffusion Layer Assembly) structure including the anode gas diffusion layer 23a and the cathode gas diffusion layer 23c. The membrane electrode assembly 25 may have the standard MEA (Membrane Electrode Assembly) structure excluding the anode gas diffusion layer 23a and the cathode gas diffusion layer 23c. In this modified structure, the anode gas diffusion layer 23a and the cathode gas diffusion layer 23c may be placed outside the MEA (i.e., on the side of the anode-side separator 26a and on the side of the cathode-side separator 26c).

### G5. Modification 5:

In the first embodiment, the controller 91a identifies the direction of electric current flowing in the variable resistance 31, based on the current value notified by the current sensor 32. In one modification, the current sensor 32 itself may identify the direction of electric current based on the measured current value. The controller 91a may make the decision of step S105 based on the direction of electric current notified by the current sensor 32.

### G6. Modification 6:

In the above description with reference to Figs. 3, 5, and 6, the fuel cell stack 10 is formed as a stack of three unit cells 20. The number of stacked unit cells is, however, not restricted to three, but the fuel cell stack 10 may be provided as a stack of two or any greater number of unit cells 20. For example, in the structures of Figs. 3, 5, and 6, the two unit cells 20a and 20b may be placed in contact with each other with omission of the unit cell 20c. In this modified structure, electrons generated at the anode a1 of the unit cell 20a are supplied to the separator s2 (i.e., the cathode-side separator 26c of the unit cell 20b) via the separator S0 and the load 200. When the unit cell 20b has hydrogen deficiency, a small value is set to the resistance value of the variable resistance 31 as in the first embodiment. The electrons supplied to the separator s2 are then supplied to the cathode c1 of the unit cell 20a via the variable resistance 31 and the separator s1.

### G7. Modification 7:

In the respective embodiments discussed above, the fuel cell system is mounted on the electric vehicle. The fuel cell system may be mounted on diversity of other moving bodies, such as hybrid vehicles, boats and ships, and robots. In other applications, the fuel cell stack 10 may be used as a stationary power source, and the fuel cell system may be incorporated in constructions, such as buildings and houses.

### G8. Modification 8:

Part of the structure implemented by the software configuration in the above embodiments may be replaced with the hardware configuration. Part of the structure actualized by the hardware configuration in the above embodiments may be replaced with the software configuration.

## Claims

1. A fuel cell system, comprising:
a first power generation module includes a power generation assembly including a catalyst, an anode-side non-power generation structure placed in contact with the power generation assembly, and a cathode-side non-power generation structure placed opposite to the power generation assembly across the power generation assembly;
a second power generation module placed adjacent to the first power generation module;
a current regulation circuit connected in parallel to each of the power generation modules; and
a current controller configured to, when a cell voltage representing a voltage between the anode-side non-power generation structure and the cathode-side non-power generation structure is not higher than a preset first voltage that is a negative voltage, control the current regulator connected in parallel to the first power generation module to increase an amount of electric current flowing in a first direction from the anode-side non-power generation structure to the cathode-side non-power generation structure.

2. The fuel cell system in accordance with claim 1, wherein the current controller includes an electric current direction detector configured to detect a direction of electric current flowing in the current regulation circuit connected in parallel to the first power generation module, and
the current controller determines whether the cell voltage is not higher than the preset first voltage, based on the direction of electric current detected by the electric current direction detector.

3. The fuel cell system in accordance with either one of claims 1 and 2, wherein when the cell voltage is higher than the preset first voltage and is higher than a preset second voltage that causes elution of the catalyst, the current controller controls the current regulation circuit connected in parallel to the first power generation module to increase an amount of electric current flowing in a second direction opposite to the first direction.

4. The fuel cell system in accordance with any one of claims 1 through 3, wherein the current regulation circuit and the current controller include a diode.

5. The fuel cell system in accordance with claim 4, wherein each of the power generation modules has a pair of separators and a membrane electrode assembly interposed between the pair of separators, and
the current regulation circuit and the current controller are placed on a circumference of the membrane electrode assembly and are interposed between the pair of separators.

6. The fuel cell system in accordance with either one of claims 4 and 5, wherein the diode is a silicon diode or a Schottky barrier diode.

7. In a fuel cell system comprising a first power generation module includes a power generation assembly including a catalyst, an anode-side non-power generation structure placed in contact with the power generation assembly, and a cathode-side non-power generation structure placed opposite to the power generation assembly across the power generation assembly, a second power generation module placed adjacent to the first power generation module, and a current regulation circuit connected in parallel to each of the power generation modules, a method of controlling electric current flowing in the current regulation circuit connected in parallel to the first power generation module,
the method comprising:
when a cell voltage representing a voltage between the anode-side non-power generation structure and the cathode-side non-power generation structure is not higher than a preset first voltage that is a negative voltage, controlling the current regulator connected in parallel to the first power generation module to increase an amount of electric current flowing in a first direction from the anode-side non-power generation structure to the cathode-side non-power generation structure.

8. In a fuel cell system comprising a first power generation module includes a power generation assembly including a catalyst, an anode-side non-power generation structure placed in contact with the power generation assembly, and a cathode-side non-power generation structure placed opposite to the power generation assembly the power generation assembly, a second power generation module placed adjacent to the first power generation module, and a current regulation circuit connected in parallel to each of the power generation modules, a program code for controlling electric current flowing in the current regulation circuit connected in parallel to the first power generation module,
the program code causing a computer to execute a program logic of, when a cell voltage representing a voltage between the anode-side non-power generation structure and the cathode-side non-power generation structure is not higher than a preset first voltage that is a negative voltage, controlling the current regulator connected in parallel to the first power generation module to increase an amount of electric current flowing in a first direction from the anode-side non-power generation structure to the cathode-side non-power generation structure.

9. A computer readable recording medium in which the program code in accordance with claim 8 is recorded.
